# EUROPEAN PATENT APPLICATION

(11) **EP 4 660 702 A2**
(43) Date of publication of application: **10.12.2025**
(21) Application number: 25207681.5
(22) Date of filing: 09.10.2025
(51) Int. Cl.: G03F 7/00

(54) **POSITION MEASUREMENT SYSTEM AND METHOD, SUBSTRATE STAGE SYSTEM, AND EXPOSURE APPARATUS**

(71) Applicant: ASML Netherlands B.V., 5500 AH Veldhoven (NL)
(72) Inventor: HEMSCHOOTE, Dries, Vaast, Paul, 5500 AH Veldhoven (NL); FISCHER, Olof, Martinus, Josephus, 5500 AH Veldhoven (NL); VAN ADRICHEM, Thomas, Paulus, Cornelis, 5500 AH Veldhoven (NL)
(74) Representative: ASML Netherlands B.V.

(57) **Abstract**

The present disclosure provides an object stage system, comprising: a balance mass having a top surface, a bottom surface, and one or more side surfaces; at least one object table movable with respect to said top surface; at least one object table follower movable with respect to a side of the balance mass and supporting a cable slab connected to a corresponding object table; a first position measurement system for measuring a first position of the at least one object table relative to the top surface in six degrees of freedom, and a second position measurement system for measuring a second position of the object table follower relative to the balance mass in six degrees of freedom.

## Description

### FIELD

The present invention relates to a position measurement system and method. The position measurement system can be applied in a substrate stage system. The substrate stage system can be applied in an exposure apparatus. The substrate herein may be a wafer or other type of substrate suitable for lithographic processing. The disclosure also relates to a lithographic apparatus including the substrate stage system.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

In semiconductor device manufacturing processes, apparatuses can be used to process and/or assess objects such as a substrate or a patterning device. An example of such an apparatus is an exposure apparatus used to generate interactions between certain radiation, for example an electromagnetic radiation or a charged-particle radiation, with a substrate. Other examples of such apparatuses are a deposition apparatus, an etching apparatus, and a die-bonding apparatus. A lithographic apparatus and an assessment apparatus are examples of an exposure apparatus. A lithographic apparatus may use an electromagnetic radiation or a charged-particle radiation to form a pattern onto a layer of radiation-sensitive material, for example a layer of photo resist, provided on a substrate. Examples of a lithographic apparatus are a deep ultraviolet (DUV) lithographic apparatus and an extreme ultraviolet (EUV) lithographic apparatus. An assessment apparatus may form interaction products resulting from interaction of an electromagnetic radiation or charged-particle radiation with an object such as a substrate or a patterning device. An inspection apparatus and a metrology apparatus are examples of such assessment apparatuses and may be used to detect particles or measure a critical dimension, for example.

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

In an everlasting effort to speed up production, substrate handling is streamlined into utmost detail. Typically, a wafer stage of a lithography apparatus has at least two substrate tables. A first substrate table may allow to perform preparatory measurements at the measure side, while a second substrate table enables exposure of another substrate at the expose side.

Typically, a substrate table comprises at least two modules which can move across a flat surface. A first module may be referred to as a long-stroke module, which allows relatively coarse and longer distance movements across said surface. A second module, which may be referred to as a short-stroke module, can be arranged on top of the long stroke module. The short stroke module herein delivers fine tuning of the position of a substrate placed on top of the module.

As described above, the wavelengths of radiation used to print patterns typically range from about 365 nm down to 13.5 nm, to print patterns of a substantially similar dimension, or even smaller. Herein, the wafer stage is provided with position measurement systems which enable position measurement of the respective substrate tables. The position measurement herein typically comprises interferometer systems or encoder-based systems, which can provide the accuracy required to fabricate nanometer scale structures.

In a dual stage exposure apparatus, the accurate position measurement system, using an interferometer system or encoder-based system, is however typically unsuitable for position measurement during operations such as a stage swap, wherein a substrate table moves from the measure side to the expose side, or vice versa. The accurate position measurement systems become unavailable or unreliable during such transitions, necessitating auxiliary measurement configurations. Known additional measurement systems applied to measure the stage position during a stage swap are typically complicated and require additional weight, which compromises the machine performance.

A conventional solution includes a mechanical arm connected to a follower module and extending to the respective substrate table, which can slide along the arm in linear direction. The arm enables mechanical referencing and position sensing. The mechanical arm however adds a significant amount of mass to be moved around, while also adding complexity. Herein, this solution limits the acceleration and dynamic responsiveness of the respective substrate table, and restricts throughput increases. Furthermore, large positional gaps that result from lagging stage setpoints are difficult to accommodate with the measurement setup, limiting scalability and performance.

US 2018335705 A1 discloses a positioning device comprising an object table and a positioning module configured to position the object table. The positioning module comprises a first positioning module member configured to hold the object table, a second positioning module member configured to support the first positioning module member, and a support frame configured to support the second positioning module member. The positioning module also includes one or more actuators, a position measurement system configured to measure a position of the object table, and a control unit configured to control a position of the object table based on the measured position of the object table. The control unit is further configured to control a vertical position of the second position module member to maintain a top surface of the second positioning module member substantially parallel to a bottom surface of the first positioning module member.

US 2014204358 A1 discloses a stage assembly for positioning a device includes: (i) a stage that retains the device; (ii) a base; (iii) a mover assembly that moves the stage along a first axis, along a second axis, and along a third axis relative to the base; (iv) a magnetic sensor system that monitors the movement of the stage along the first, second and third axes, the magnetic sensor system generating a magnetic sensor signal; (v) a second sensor system that monitors the movement of the stage along the first, second and third axes, the second sensor system generating a second sensor signal; and (vi) a control system that controls the mover assembly using at least one of the magnetic sensor signal and the second sensor signal.

US 2024168393 A1 discloses a positioning device for positioning a stage relative to a tool mounted on a carrier device includes two intersecting linear axes disposed one above the other for pre-positioning the stage. A first magnetic levitation unit is configured to support the stage on one of the linear axes, the stage being actively movable for fine positioning in six degrees of freedom. A measuring head and first and second 6-DOF encoders are configured to determine a position of the stage relative to the carrier device. The measuring head is mounted on the other linear axis. The first 6-DOF encoder is disposed between the carrier device and the measuring head and the second 6-DOF encoder is disposed between the measuring head and the stage. A second magnetic levitation unit disposed on the other linear axis is configured to actively move the measuring head in the six degrees of freedom.

In view of the above, there is a need for an improved substrate stage system provided with suitable means to measure the position of substrate stages over relatively long distances, for instance during stage swaps..

### SUMMARY

The disclosure provides an object stage system, comprising:
a balance mass having a top surface, a bottom surface, and one or more side surfaces;
at least one object table movable with respect to said top surface;
at least one object table follower movable with respect to a side of the balance mass and supporting a cable slab connected to a corresponding object table;
a first position measurement system for measuring a first position of the at least one object table relative to the top surface in six degrees of freedom, and
a second position measurement system for measuring a second position of the object table follower relative to the balance mass in six degrees of freedom.

In an embodiment, the first and/or second position measurement system comprise at least one magnetism sensor for determining a translation based on a magnetic field of a magnetic drive system included in the balance mass.

In an embodiment, the at least one magnetism sensor is a Hall sensor.

In an embodiment, the first and/or second position measurement system comprises at least one optical sensor for sensing a surface topography of a surface of the balance mass.

In an embodiment, the first position measurement system includes one or more height sensors for measuring a vertical distance between the respective object table and the top surface of the balance mass.

In an embodiment, the object stage system comprises a control system adapted to position the at least one object table during a stage swap using feedback from the first position measurement system and the second position measurement system.

In an embodiment, the cable slab is the only mechanical connection between the object table follower and the corresponding object table.

According to another aspect, the disclosure provides an exposure apparatus, comprising at least one object stage system comprising:
a balance mass having a top surface, a bottom surface, and one or more side surfaces;
at least one object table movable with respect to said top surface;
at least one object table follower movable with respect to a side of the balance mass and supporting a cable slab connected to a corresponding object table;
a first position measurement system for measuring a first position of the at least one object table relative to the top surface in six degrees of freedom, and
a second position measurement system for measuring a second position of the object table follower relative to the balance mass in six degrees of freedom.

In an embodiment, the apparatus comprises a control system adapted to position the at least one object table during a stage swap of the at least one object table using feedback from the first position measurement system and the second position measurement system.

According to another aspect, the disclosure provides a method for positioning an object, the method comprising the steps of:
providing a balance mass having a top surface, a bottom surface and side surfaces;
movably arranging at least one object table with respect to the top surface;
providing at least one object table follower which is movable with respect to the balance mass and supports a cable slab connected to a corresponding object table;
moving the at least one object table across the top surface and simultaneously moving the corresponding object table follower along the balance mass;
measuring a first position of the at least one object table relative to the top surface in six degrees of freedom using a first position measurement system, and
measuring a second position of the object table follower relative to the balance mass in six degrees of freedom using a second position measurement system.

In an embodiment, the step of measuring the first position comprises using one or more Hall sensors comprised in the at least one object table to determine a horizontal position relative to a reference position based on the magnetic field of a magnet array comprised in the balance mass.

In an embodiment, the step of measuring the first position comprises using one or more optical sensors comprised in the at least one object table to determine a position based on a topography of the top surface of the balance mass.

In an embodiment, the step of measuring the second position of the object table follower comprises:
- measuring translation along a side surface of the balance mass using a sensor and an indicator arranged on the side surface;
- measuring distance with respect to the side of the balance mass using one or more sensors; and
- measuring distance with respect to the bottom surface of the balance mass using one or more sensors.

In an embodiment, the cable slab is the only mechanical connection between the object table follower and the corresponding object table.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a side view of an exemplary object stage of a lithographic apparatus;
- Figure 3A depicts a top view of an object stage of a lithographic apparatus;
- Figure 3B depicts a perspective view of a detail of the object stage of Figure 3A;
- Figure 3C depicts a schematic side view of a detail of the object stage of Figure 3A;
- Figure 4A depicts a top view of an embodiment of an object stage;
- Figure 4B depicts a perspective view of a detail of the object stage of Figure 4A;
- Figure 4C depicts a schematic and cross-sectional side view of an embodiment of an object stage; and
- Figure 4D depicts a schematic and cross-sectional side view of another embodiment of an object stage.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

The term "overlay error" as used herein refers to horizontal placement error between respective layers of a lithographic process. Said horizontal error may typically impact the quality of a chip. One key task of a lithography apparatus is the ability to image dense lines and spaces from the mask to the wafer. Here, the critical dimension (the width of a line), the pitch (the distance between lines) and the straightness of each of the lines are important, as well as overlay error.

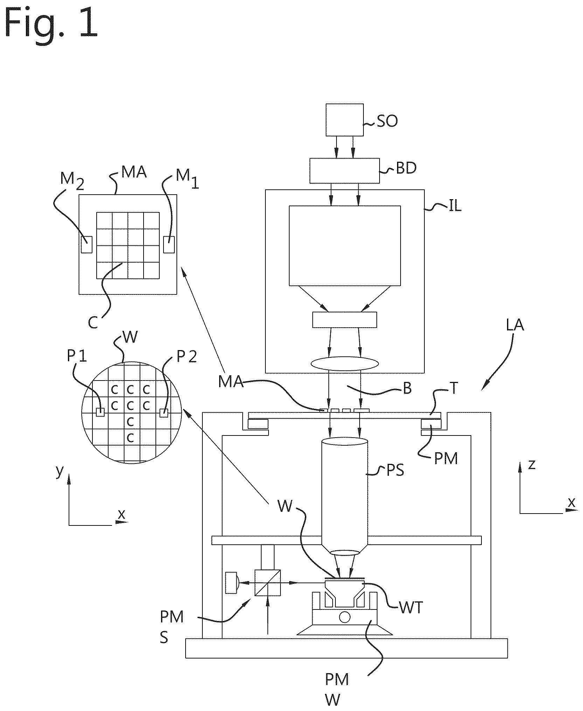

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PMW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

As depicted in Figure 1, the lithographic apparatus is of a transmissive type (e.g. employing a transmissive mask and lenses). Alternatively, the apparatus may be of a reflective type (e.g. employing a programmable mirror array of a type as referred to above, or employing a reflective mask).

The lithographic apparatus LA may be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PMW and a position measurement system PMS, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B.

Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axes, i.e., an x-axis, a y-axis and a z-axis. Each of the three axes is orthogonal to the other two axes. A rotation around the x-axis is referred to as an Rx-rotation. A rotation around the y-axis is referred to as an Ry-rotation. A rotation around the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

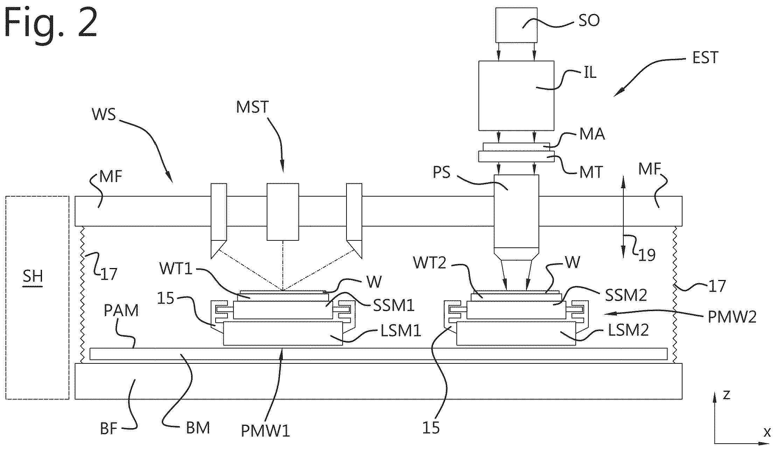

Figure 2 shows an exemplary overview of a substrate stage WS. A base frame BF supports the substrate stage. The base frame basically is a frame having or providing a reference position. The reference position is typically substantially fixed with respect to the environment.

The substrate stage WS may comprise one, two or more substrate supports WT1, WT2. The substrate supports are moveable with respect to a planar surface PAM. The planar surface may be a top surface of a balance mass BM. The balance mass may provide movement compensation for movement of the substrate supports based on inertia with respect to the base frame.

Positioning modules PMW1, PMW2 of each substrate support WT1, WT2 may comprise a first module LSM1, LMS2, also referred to as a "long stroke module". The positioning modules PMW1, PMW2 may comprise a second module SSM1, SSM2, also referred to as a "short stroke module". The respective short stroke modules SSM1, SSM2 may typically be able to move with respect to the corresponding long stroke modules LSM1, LSM2. The short stroke modules SSM1, SSM2 may be connected to the respective long stroke modules LSM1, LSM2 via one or more actuators 15.

Other parts of the machine, such as the first positioner PM, may also comprise a comparable two-module setup, comprising a long stroke module and a corresponding short stroke module. Also, a similar two-part setup can be applied in other equipment as well, such as an exposure apparatus, measurement tools, wafer handlers, etc.

The long stroke modules LSM1, LSM2 may typically enable relatively fast movement over a relatively large range of motion. The short stroke modules may enable very accurate movements over a relatively small range of motion. The combination of the long-stroke module and the short-stroke module enables a respective second positioner PMW to move the corresponding substrate support WT relative to the projection system PS with high accuracy and over a large range of movement.

The short stroke modules SSM1, SSM2 are movable with respect to the corresponding long stroke modules LSM1, LSM2. Depending on a particular application, said movement can be in any degree of freedom required, including one or more of translations in one or more of x, y, z direction or rotation around one or more of said directions (Rx, Ry, Rz).

Relatively large horizontal forces due to repeated acceleration and deceleration of positioning modules PMW1, PMW2 can at least partially be absorbed using a balance mass principle. Herein, the balance mass unit BM can be arranged between the one or more substrate supports and the base frame BF. The balance mass BM may typically include the substantially flat and planar top surface PAM.

The balance mass BM may typically be connected to the base frame via one or more bearings, which in turn may be provided in or on a bearing frame. The bearing frame may be connected to the base frame BF via support legs. The bearings may be air bearings, and the bearing frame may be an air bearing frame. An actuator or comparable controller may be arranged between a horizontal edge of the balance mass BM and the base frame BF. The actuator or comparable controller element may dampen or obviate horizontal drift of the balance mass with respect to the base frame. The latter is not shown in detail in the figures.

The substrate stage WS may comprise drive means for moving the long stroke modules LSM1, LSM2 with respect to the surface PAM. The drive means may be based on, for instance, a mechanical direct drive, or electromagnetic drive means. An electromagnetic drive system may comprise, for instance, an array of electromagnets arranged in the balance mass BM and/or in the long stroke modules LSM1, LSM2.

For instance, a planar motor concept may be implemented to realize horizonal accelerations of the respective long stroke modules. A planar motor may include a magnet array, forming a so-called Magnet Plate. The magnet array can be arranged, for instance, on top of the balance mass BM or may be integral to the balance mass BM. The magnet array herein may contribute to the total mass of the balance mass BM. Alternatively, a magnet array formed by (superconductive) magnetic coils may be included in the balance mass. Corresponding magnetic coils of the planar motor concept may be comprised in or on the bottom surface of a respective long stroke module LSM1, LSM2.

One or more substrate handlers SH may be arranged adjacent to the substrate stage WS. The substrate handler typically comprises one or more storage positions WSL for holding a stack of substrates. The stack of substrates may also be referred to as a substrate lot WL. A substrate lot herein typically comprises a number of substrates each intended for a specific step in a lithographic process. Each substrate handler may be provided with one or more robot arms RA for transferring substrates W from one of the storage locations WSL to one of the substrate tables, or vice versa.

The substrate stage may be provided with an exposure station EST. The exposure station may refer to a location or area where a substrate W positioned on one of the one or more substrate tables can be exposed to radiation for patterning resist on said substrate. See also Figure 1 and the related description above.

The substrate stage may be provided with another location or area intended for executing certain measurements. Said location or area may be referred to as measurement station MST. The measurements herein may include, but are not limited to, pre-expose measurements - such as surface, height, and topography mapping, and accurate positioning - and post-expose measurements such as control of exposed patterns. The measurement station MST, see Figure 2, may include one or more sensors and related control equipment intended for the measurements as referenced. However, said sensors may also be included in or on the respective substrate tables or at any other viable position.

The exposure station EST and/or the measurement station MST may be arranged in or connected to a metrology frame MF. The metrology frame MF may be connected to the environment via an isolating connection 17. The isolating connection 17 may comprise, for instance, one or more air mounts. The isolating connection may be vertically adjustable, allowing to adjust a vertical position of the metrology frame MF, as indicated by arrow 19.

Please note that the setup shown in Figure 2 is exemplary and serves as a reference. Many other setups for a substrate stage WS or respective substrate tables are conceivable. Basically, the figures exemplify how a substrate stage may comprise multiple substrate tables which can move individually with respect to each other and be involved in different steps of the lithographic process in parallel. Also, the two-part setup of long stroke modules and short stroke modules can be applied to move other equipment as well, such as but not limited to optical elements, reticle tables, and mask tables. Examples include the first positioner PM and the second positioner PMW shown in Figure 1.

As described above, the semiconductor industry is involved in an ongoing effort to speed up production, to make printed patterns smaller and more accurate, or both.

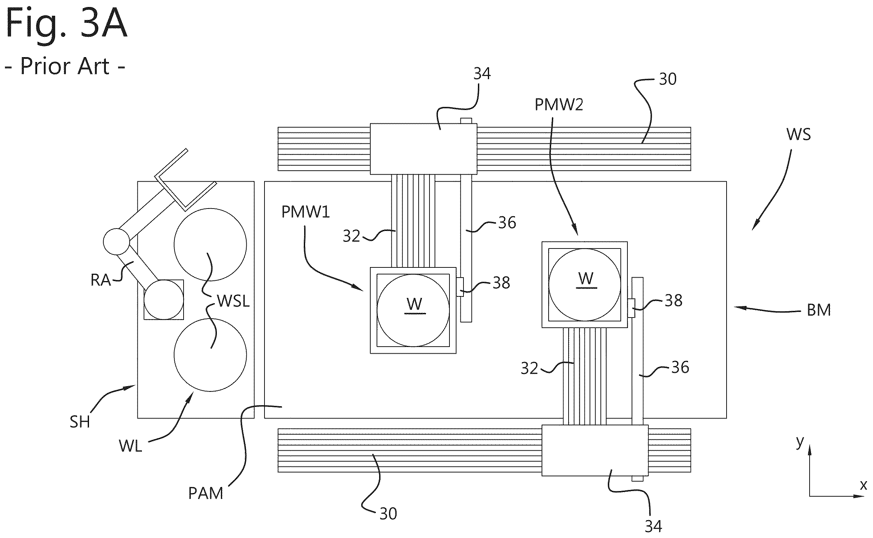

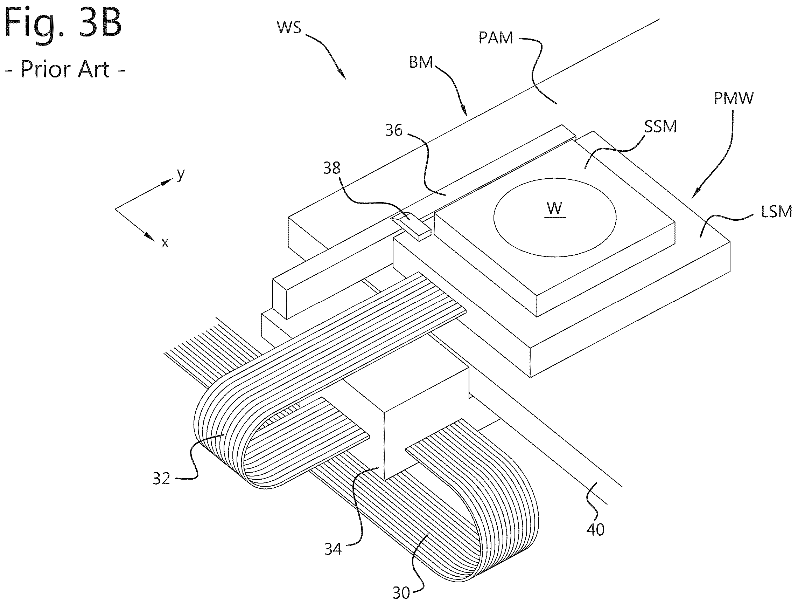

Generally referring to Figure 3A and 3B, a conventional substrate stage WS may typically comprise two positioning modules PMW1, PMW2 with corresponding substrate support tables WT1, WT2. The long stroke modules LSM1, LSM2 enable planar movement of the respective modules with respect to the surface PAM. During operation, the two positioning modules regularly switch between the measurement station MST and the expose station EST. When located at the respective stations, the positioning modules make predetermined movements in x-direction and y-direction across the top surface PAM of the balance mass BM.

During operation, each positioning module will typically have to be provided with one or inputs, such as one or more of (electrical) power, cooling, and data exchange. The respective inputs may also require a return from the respective positioning module. To enable inputs and outputs to a movable module, each positioning module is typically connected to a so-called movable cable track.

A movable cable track, also known as cable slab, cable protector, cable drag chain, or cable carrier, as meant herein is an assembly or system for holding and protecting a set of cables, lines or hoses while allowing movement. The movement may typically be limited to a linear direction, typically aligned with the longitudinal direction of the respective cables. A cable slab or track may typically comprise a flexible, hollow system designed to guide, support, and protect cables, hoses, and hydraulic lines during movement of the positioning modules. The cable track may comprise interconnected links, often made of plastic or metal, that safeguard the cables comprised in the cable track from damage, tangling, and wear and tear, ensuring reliable operation during an extended time.

In the example shown in Figure 3A, each positioning module PMW1, PMW2 is connected to a first cable track 30 and to a second cable track 32. The first cable track enables linear movement in a first direction along a first axis or x-axis. In the example, said linear movement in the x-direction extends along a respective side of the balance mass BM.

The first cable track 30 has one end connected to one or more inputs (not shown) and an opposite end connected to an intermediate module 34. The intermediate module is connected to one end of the second cable track 32, whereas an opposite end of the second cable track is connected to a respective positioning module PMW1, PMW2. Herein, the second cable track 32 enables at least linear movement in a second direction, along a second axis or y-axis. Said second direction or y-axis is substantially perpendicular to the x-axis, i.e. to the first direction.

In operation, the positioning modules and their corresponding substrate tables WT1, WT2 move horizontally across the top surface PAM of the balance mass, relative to the balance mass BM. Herein, the intermediate module 34 typically moves in the first direction, i.e. in linear direction along a side 40 of the balance mass. Conventionally, the movement of the intermediate module 34 follows movement of the respective positioning module along the x-axis as accurately as possible, to minimize or completely prevent torque or twist of the second cable carrier 32. In the method and system of the present disclosure, however, some difference between respective setpoints may be allowed, as described herein below. The intermediate module 34 may also be referred to as the "Linear Axis", the "follower module", or merely the "follower".

In the conventional setup shown in Figures 3A and 3B, the follower module 34 is provided with an arm or beam 36 extending to the respective positioning module. The positioning module PMW can slide along the beam using a slidable coupling 38. The slidable coupling enables the positioning module PMW to move in longitudinal direction along the beam 36. The beam 36 and the coupling 38 limits relative movements of the respective positioning module with respect to the follower module. Thus, the beam 36 may prevent equipment trip or damage, by mechanically limiting movement of the respective positioning module PMW. For instance, the mechanical beam 36 prevents the positioning module PMW from crashing into outer limits of the surface PAM in case of system failure.

Finally, the slidable coupling 38 enables a relatively course position measurement. For instance, the beam 36 can be provided with position indicators, such as a ruler type indication. The coupling 38 can be provided with a sensor to check where along said position indicators the positioning module PMW is located. Thus, the beam 36 can assist in position indication during a stage swap, wherein the first positioning module PMW1 moves from the expose station EST to the measure station MST, while the second positioning module PMW2 moves from the measure station MST to the expose station EST, or vice versa.

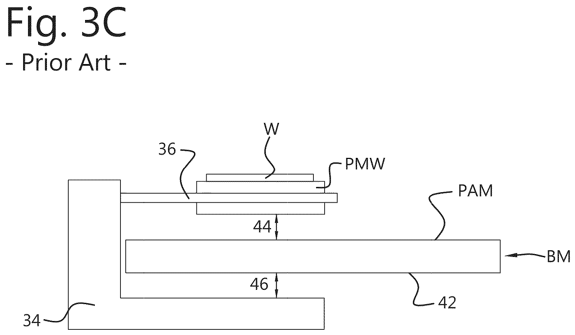

Generally referring to Figure 3C, the setup as described above with respect to Figures 3A and 3B provides a system wherein the intermediate module 34 measures its position along the x-axis with respect to the balance mass BM. The intermediate module herein typically has a sensor for detecting a position indicator on, for instance, a lower surface 42 or the side 40 of the balance mass. The positioning module PMW can move in the horizontal plane across the top surface PAM of the balance mass. The positioning module herein is linearly movable in y-direction with respect to the beam 36 which in turn is fixed to the follower module 34. A course position indication of the positioning module PMW, as required during for instance a stage swap between the expose and measure side, can be determined by the position of the follower module (x-axis) and the position of the positioning module w along the beam 36 (y-axis).

As indicated by the arrows 44, 46, the system may also include mechanisms or sensors to monitor vertical distance (Δz) between the balance mass BM and the positioning module PMW and the follower module 34 respectively.

Thus, the substrate table can move, typically slide, along the beam 36, while the arm restricts movement of the substrate table in a direction perpendicular to the longitudinal axis of the arm. Thereby, the mechanical arm can provide a course position measurement (for instance, using position indicators, such as a ruler, arranged on a surface of the arm) while also providing a mechanical crash prevention in case of an error, such as an interruption in control or power signals. As described in the introduction, however, the mechanical arm introduces a significant mass, which has to move synchronous with the respective follower module. Significant herein can mean an added mass on the order of 10 to 30% extra. For instance, the mechanical beam 36 adds a mass on the order of 10 to 15 kg (of the mechanical arm and its substructures) to the mass of the respective follower module . Said mass has to move while the system also has to displace the corresponding substrate table, which is typically in the 40 to 60 kg range (this includes the mass of the long stroke module LSM and the short stroke module SSM). Herein, also the slidable coupling adds mass, yet to the positioning module.

To limit the mass and improve the responsiveness of the system, it is an aim to remove the arm. However, if the arm 36 is removed, the measurement system described above is unsuitable. The system therefore requires a new measurement system to control the respective positions of the positioning module PMW and the follower module 34.

Therefore, the present disclosure introduces a measurement system to measure the position of the positioning module PMW and the follower module 34 with respect to the balance mass. The measurement system of the present disclosure provides an increased tolerance for differences in setpoint, including lag or lead, of the follower module with respect to the positioning module. The measurement system as disclosed herein provides an indication of the position of the respective positioning module PMW on the balance mass surface PAM, suitable for use during a swap of respective positioning modules from one side of the balance mass (for example, the measure station MST) to another (for example, the expose station EST), and vice versa.

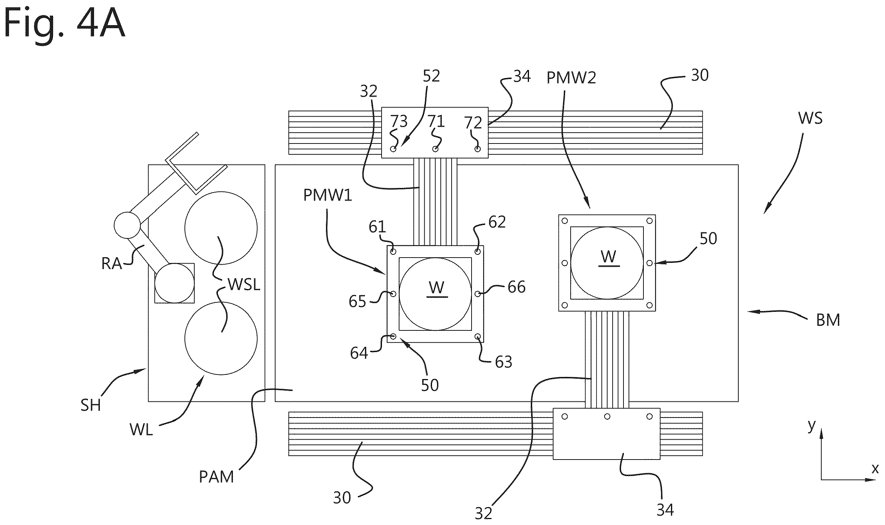

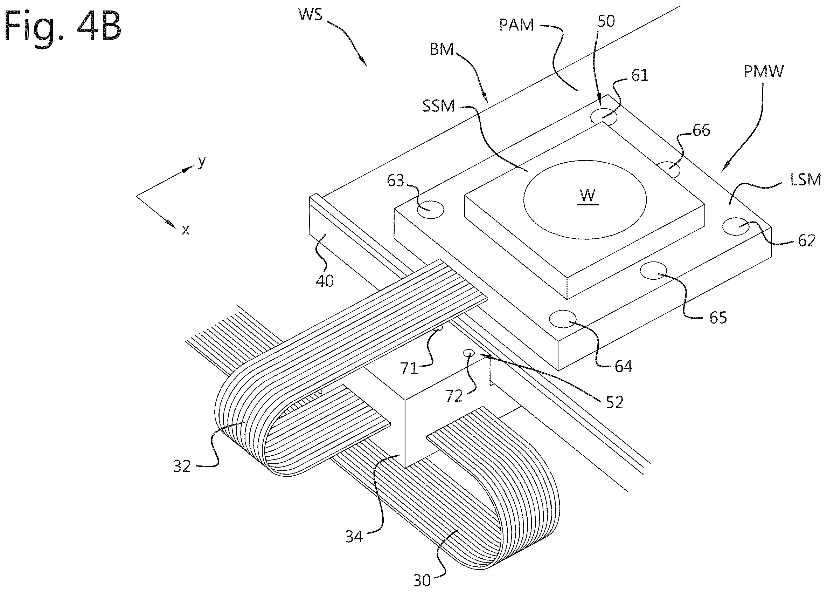

Generally referring to Figures 4A and 4B, in an embodiment, the system of the present disclosure comprises a first position measurement system 50 and a second position measurement system 52. The first measurement system 50 may comprise a number of first sensors 61 to 66. The second measurement system 52 may comprise a number of second sensors 71 to 76.

The first position measurement system 50 may be adapted to measure a relative position of one of the positioning modules PMW with respect to the balance mass BM. In a preferred embodiment, the first position measurement system 50 may be adapted to measure a relative position of one of the long stroke modules LSM of a respective positioning module PMW with respect to the balance mass. The second position measurement system 52 may be adapted to measure a relative position of a respective follower module 34 with respect to the balance mass.

The first position measurement system 50 and the second position measurement system 52 can preferably measure the relative positions in six degrees of freedom. These six degrees of freedom include translation in x, y and z, and rotation around x, y and z (Rx, Ry, Rz). The translations and rotations may be defined with respect to a suitable reference, for example with respect to the balance mass.

In an embodiment, the first measurement system 50 (for a substrate stage) may co-operate with the top surface PAM of the balance mass BM. The second measurement system 52 (for the follower 34) may co-operate with one of the side surfaces 40 and/or lower surface 42 of the balance mass BM.

In an embodiment, the first position measurement system 50 can measure a relative position of one of the positioning modules PMW with respect to the balance mass. Herein, the first position measurement system 50 can measure translation (x, y, z) and rotation (Rx, Ry, Rz) of the respective positioning module PMW with respect to the top surface PAM of the balance mass BM.

The second position measurement system 52 can measure a relative position of one of the follower modules 34 with respect to the balance mass. Herein, the second position measurement system 52 can measure translation (x, y, z) and rotation (Rx, Ry, Rz) of the respective follower module 34 with respect to the balance mass BM.

In an embodiment, the first sensors of the first position measurement system 50 include four height sensors 61, 62, 63, 64. The vertical distance between the positioning module PMW and the top surface PAM of the balance mass may be on the order of micrometers to a few millimeter. The height sensors may be suitable for use in state of the art equipment. The height sensors may be optical sensors, for instance laser based sensors, as sold by, for instance, Keyence Corp. [US], Elovis GmbH [DE], or Mitutoyo [JP].

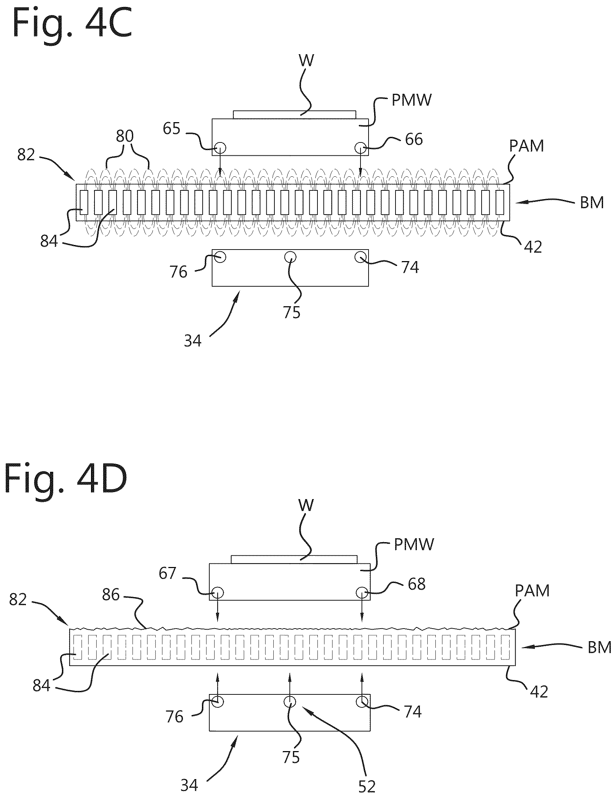

In an embodiment, the first sensors of the first position measurement system 50 include one or more magnetism sensors. For instance, the first sensors include one or more Hall sensors 65, 66 (Figure 4C). The magnetism sensors 65, 66 may measure a magnetic field pattern 80 created by a magnet array 82 included in the balance mass BM. The magnet array 82 may typically include a matrix or grid of evenly distributed magnets 84. The magnets 84 may, for instance, be spaced at a pitch on the order of 20 to 100 mm. Pitch herein typically refers to a mutual distance between adjacent magnets 84 of the array 82. Adjacent magnets are typically arranged in opposite phase, i.e. one magnet is arranged with its magnetic north facing upward, while the next magnet is arranged with its magnetic south facing upward, et cetera.

A Hall sensor (or Hall-effect sensor) as meant herein is a transducer that varies its output voltage in response to a magnetic field. It is based on the Hall effect, discovered by Edwin Hall, which states that when a current-carrying conductor or semiconductor is placed in a magnetic field perpendicular to the current, a voltage (the Hall voltage) is generated across the conductor in a direction perpendicular to both the current (in the conductor) and the (external) magnetic field. Hall sensors may be either analog or digital. Analog Hall Sensors produce a continuous output voltage proportional to the magnetic field strength. Digital Hall Sensors typically use a Schmitt trigger or comparator to provide a binary (on/off) signal depending on whether the magnetic field exceeds a threshold.

A Hall sensor may, for instance, comprise a thin strip of conductive or semiconductive material. During operation, a constant current is passed through the strip. When the Hall sensor is exposed to a magnetic field perpendicular to the current, charge carriers (electrons or holes) are deflected due to the Lorentz force. This deflection causes a measurable potential difference (Hall voltage) across the material. The Hall voltage is proportional to the strength of the applied magnetic field and can be processed by electronic circuits to provide usable signals.

For the system of the present disclosure, see for instance Figure 4C, the direction of the magnetic field 80 as provided by the magnet array 82 with respect to the respective Hall sensor 65, 66 changes depending on the position of the latter sensor. Thus, when the positioning module PMW moves (horizontally) across the balance mass, its one or more Hall sensors 65, 66 provide a voltage which changes as a function of said position.

As described herein above, the magnet array 82 typically includes a periodic grid or matrix of magnets 84. The Hall sensors can be provided with a reference or stating position. Starting from said reference, the Hall sensors allow to calculate or estimate a change in horizontal position with respect to said reference, based on the Hall effect and the pitch of the magnets 84.

To increase accuracy, the Hall sensor measurements can be combined with accelerometer measurements. The positioning module may include one or more accelerometers.

To include the effect of variations in height of the positioning module PMW with respect to the balance mass BM on the output of the respective Hall sensors, the measurements of the one or more height sensors 61, 62, 63, 64 can be considered.

In an embodiment, the first sensors of the first position measurement system 50 include one or more optical position sensors. For instance, the first sensors include one or more optical position sensors 67, 68 (Figure 4D). The one or more optical sensors 67, 68 can determine a position of the respective sensor based on a topography 86 of the surface of the balance mass. Herein, before operation, said topography can be scanned and mapped, providing a reference. During operation, signals provided by the respective optical sensors 67, 68 can be compared to said reference to determine a (horizontal) position of the respective sensor with respect to the top surface PAM of the balance mass.

To allow the follower module 34 to follow the positioning module PMW, a gap between both is not directly measured. Instead, said gap can be derived from position measurements of the positioning module with respect to the balance mass, and of the follower module 34 with respect to the balance mass.

In an embodiment, the second position measurement system 52 may include second sensors 71 to 76. Second sensor one 71 may measure a linear position along the balance mass. The second sensor one 71 herein may measure an indicator on the side 40 or on a lower surface 42 of the balance mass. The indicator may include, for instance, a ruler or visual indicator. One or more other second sensors 72, 73 may measure a gap or distance in y-direction of the follower module 34 with respect to the balance mass. Second sensors two 72 and three 73 may be referred to as y-diff sensors. Second sensors four 74, five 75 and six 76 may measure a gap or distance in z-direction of the follower module 34 with respect to the balance mass. Second sensors four 74, five 75 and six 76 may be referred to as z-diff sensors.

Distance measurements of the follower module 34 with respect to the balance mass BM, either in horizontal direction (y-diff) and vertical direction (z-diff) can also enable to determine rotation of the follower module around respective axes. For instance, horizontal distance measurements enable to determined rotation around the vertical axis (Rz). Vertical distance measurements (z-diff) enable to determine rotation around the horizontal axes (Rx, Ry).

The system of the present disclosure may include a control system adapted to position the at least one positioning module PMW during a stage swap. Herein, the control system can use feedback from the first position measurement system 50 and the second position measurement system 52. The position measurements provided by the respective position measurement systems 50, 52 enables to determine a position of the positioning module and the associated substrate table even at times when the positioning module moves outside of range of the interferometer-based position measurement systems of the expose station and measure station.

As referenced herein above, the beam 36, which is required for the conventional measurement configuration, increases the mass of the overall system, which limits the acceleration of the follower module 34. The reduced dynamics of the follower module in turn limit the closed loop control bandwidth of a control system controlling movements of the system.

To increase acceleration of the stage, also the acceleration of the follower module in x-direction will have to increase. The system of the present disclosure enables to limit the required actuation force of the follower module 34, allowing to further increase the acceleration. The system herein reduces the mass of the follower module by removing the beam 36. This is combined with a new measurement system to determine the relative position of the positioning module PMW and the follower module 34. The system herein optionally includes a control system to actively limit the range of the positioning module.

Optionally, the system includes a dedicated, "smoother" setpoint for the follower module 34. The latter may be referred to as a lagging or leading follower setup. In general, the follower module will be provided with its own, dedicated setpoint which may (slightly) differ from the setpoint for the substrate table. For significant force reduction, a gap resulting from the setpoint difference between the long stroke module and the follower module may increase to an order of about 10 mm. Such a large gap cannot be solved by conventional systems, while the measurement system of the present disclosure can handle the difference in setpoint.

Obviating the beam 36 reduces costs and weight. Mass of the overall system can be reduced with about 10 kg or with about 15 to 25%, for instance about 20%. The mass reduction includes both the removal of the arm and the option to use a simpler shuttle for the follower module 34. The reduced mass and the ability to apply larger gaps between the positioning module and the follower module enables faster stage moves, enabling to increase throughput. Throughput may increase, for instance, from about 300 substrates per hour to a throughput exceeding 400 substrates per hour.

The embodiments as described herein above may be equally applicable to a wide range of lithography apparatuses. For instance, the embodiments can be applied to DUV systems and EUV systems, allowing to process a wider range of (thicker) substrates.

Although specific reference may be made in this text to the use of a lithographic apparatus in the manufacture of ICs, the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These devices may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below. For instance, features of various embodiments as described above may be combined.

## Claims

1. An object stage system, comprising:
a balance mass having a top surface, a bottom surface, and one or more side surfaces;
at least one object table movable with respect to said top surface;
at least one object table follower movable with respect to a side of the balance mass and supporting a cable slab connected to a corresponding object table;
a first position measurement system for measuring a first position of the at least one object table relative to the top surface in six degrees of freedom, and
a second position measurement system for measuring a second position of the object table follower relative to the balance mass in six degrees of freedom.

2. System of claim 1, wherein the first and/or second position measurement system comprise at least one magnetism sensor for determining a translation based on a magnetic field of a magnetic drive system included in the balance mass.

3. System of claim 2, wherein the at least one magnetism sensor is a Hall sensor.

4. System of claim 1, wherein the first and/or second position measurement system comprises at least one optical sensor for sensing a surface topography of a surface of the balance mass.

5. System of one of the previous claims, wherein the first position measurement system includes one or more height sensors for measuring a vertical distance between the respective object table and the top surface of the balance mass.

6. System of one of the previous claims, comprising a control system adapted to position the at least one object table during a stage swap using feedback from the first position measurement system and the second position measurement system.

7. System of one of the previous claims, wherein the cable slab is the only mechanical connection between the object table follower and the corresponding object table.

8. An exposure apparatus, comprising at least one object stage system comprising:
a balance mass having a top surface, a bottom surface, and one or more side surfaces;
at least one object table movable with respect to said top surface;
at least one object table follower movable with respect to a side of the balance mass and supporting a cable slab connected to a corresponding object table;
a first position measurement system for measuring a first position of the at least one object table relative to the top surface in six degrees of freedom, and
a second position measurement system for measuring a second position of the object table follower relative to the balance mass in six degrees of freedom.

9. The apparatus of claim 8, comprising a control system adapted to position the at least one object table during a stage swap of the at least one object table using feedback from the first position measurement system and the second position measurement system.

10. A method for positioning an object, the method comprising the steps of:
providing a balance mass having a top surface, a bottom surface and side surfaces;
movably arranging at least one object table with respect to the top surface;
providing at least one object table follower which is movable with respect to the balance mass and supports a cable slab connected to a corresponding object table;
moving the at least one object table across the top surface and simultaneously moving the corresponding object table follower along the balance mass;
measuring a first position of the at least one object table relative to the top surface in six degrees of freedom using a first position measurement system, and
measuring a second position of the object table follower relative to the balance mass in six degrees of freedom using a second position measurement system.

11. The method of claim 10, wherein the step of measuring the first position comprises using one or more Hall sensors comprised in the at least one object table to determine a horizontal position relative to a reference position based on the magnetic field of a magnet array comprised in the balance mass.

12. The method of claim 10, wherein the step of measuring the first position comprises using one or more optical sensors comprised in the at least one object table to determine a position based on a topography of the top surface of the balance mass.

13. The method of one of claims 10 to 12, wherein the step of measuring the second position of the object table follower comprises:
- measuring translation along a side surface of the balance mass using a sensor and an indicator arranged on the side surface;
- measuring distance with respect to the side of the balance mass using one or more sensors; and
- measuring distance with respect to the bottom surface of the balance mass using one or more sensors.

14. The method of one of claims 10 to 13, wherein the cable slab is the only mechanical connection between the object table follower and the corresponding object table.
